# EUROPÄISCHE PATENTSCHRIFT

(11) **EP 1 259 663 B1**
(45) Veröffentlichungstag und Bekanntmachung des Hinweises auf die Patenterteilung: **28.10.2009**
(21) Anmeldenummer: 01921157.2
(22) Anmeldetag: 02.03.2001
(51) Int. Cl.: C30B 11/00, C30B 29/12

(54) **VERFAHREN UND VORRICHTUNG ZUR ZÜCHTUNG VON GROSSVOLUMIGEN ORIENTIERTEN EINKRISTALLEN**
METHOD AND DEVICE FOR GROWING LARGE-VOLUME ORIENTED MONOCRYSTALS
PROCEDE ET DISPOSITIF DE CULTURE DE MONOCRISTAUX ORIENTES DE GROS VOLUME

(30) Priorität: 03.03.2000 DE 10010484
(43) Veröffentlichungstag der Anmeldung: 27.11.2002
(60) Teilanmeldung: 06023376.4
(73) Patentinhaber: Schott AG, 55122 Mainz (DE)
(72) Erfinder: WEHRHAN, Gunther, 07749 Jena (DE); ELZNER, Peter, 65391 Lorch (DE); MÖRSEN, Ewald, 55130 Mainz (DE); SCHATTER, Richard, 65817 Eppstein /Bremthal (DE); AXMANN, Hans-Jörg, 07745 Jena (DE); REICHARDT, Thorsten, 07646 Stadtroda (DE)
(74) Vertreter: Fuchs
(86) Internationale Anmeldenummer: PCT/DE2001/000790
(87) Internationale Veröffentlichungsnummer: WO 2001/064975

(56) Entgegenhaltungen:
- EP-A- 0 338 411
- DE-A- 3 323 896
- DE-A- 19 912 484
- ALTHAUS M ET AL: "Some new design features for vertical Bridgman furnaces and the investigation of small angle grain boundaries developed during VB growth of GaAs" JOURNAL OF CRYSTAL GROWTH,NL,NORTH-HOLLAND PUBLISHING CO. AMSTERDAM, Bd. 166, Nr. 1, 1. September 1996 (1996-09-01), Seiten 566-571, XP004053410 ISSN: 0022-0248
- PATENT ABSTRACTS OF JAPAN vol. 1999, no. 08, 30. Juni 1999 (1999-06-30) & JP 11 079880 A (NIKON CORP;OYO KOKEN KOGYO KK), 23. März 1999 (1999-03-23)
- PATENT ABSTRACTS OF JAPAN vol. 1998, no. 09, 31. Juli 1998 (1998-07-31) & JP 10 101484 A (CANON INC), 21. April 1998 (1998-04-21)
- SABHARWAL: "A TECHNIQUE FOR GROWTH OF ALKALI HALIDE CRYSTALS IN STATIONARY CRUCIBLE" JOURNAL OF CRYSTAL GROWTH., Bd. 80, Nr. 1, Januar 1987 (1987-01), Seiten 33-36, XP002169789 NORTH-HOLLAND PUBLISHING CO. AMSTERDAM., NL ISSN: 0022-0248
- HOROWITZ: "THE GROWTH OF SINGLE CRYSTALS OF OPTICAL MATERIALS VIA THE GRADIENT SOLIDIFICATION METHOD" JOURNAL OF CRYSTAL GROWTH., Bd. 85, Nr. 1-2, 1. November 1987 (1987-11-01), Seiten 215-222, XP002169790 NORTH-HOLLAND PUBLISHING CO. AMSTERDAM., NL ISSN: 0022-0248

## Beschreibung

Die Erfindung betrifft ein Verfahren zur Züchtung von großvolumigen Einkristallen einheitlicher Orientierung aus einer Schmelze, eine Vorrichtung zur Durchführung dieses Verfahrens sowie die Verwendung derart hergestellter Kristalle.

Einkristalle zeichnen sich dadurch aus, dass sie über ihr gesamtes Volumen hinweg eine einheitliche Orientierung aufweisen, was eine Voraussetzung dafür ist, daß eine hohe optische Homogenität im gesamten Kristallvolumen vorliegt. Aus diesem Grunde eignen sie sich hervorragend zur Verwendung in der optischen Industrie oder auch als Ausgangsmaterial für optische Komponenten in der DUV-Fotolithographie wie für Stepper oder Excimerlaser.

Das Züchten von Einkristallen aus der Schmelze ist an sich bekannt. In Lehrbüchern zur Kristallzucht wie beispielsweise dem 1088 Seiten umfassenden Werk von K.-Th. Wilke und J. Bohm, "Kristallzüchtung" werden die unterschiedlichsten Verfahren zum Züchten von Kristallen beschrieben, wovon im folgenden die häufigsten Techniken kurz erwähnt werden. Prinzipiell können Kristalle aus der Gasphase, der Schmelze, aus Lösungen oder sogar aus einer festen Phase durch Rekristallisation oder Festkörperdiffusion gezüchtet werden. Diese sind jedoch meist nur für den Labormaßstab gedacht und nicht für die großtechnisch industrielle Fertigung geeignet. Die wichtigsten großtechnischen Schmelzzüchtungsverfahren zur Herstellung von Kristallen sollen im folgenden kurz erläutert werden.

Beim Czochralski-Verfahren wird ein leicht gekühlter Kristallkeim mittels eines Fingers in einen Tiegel mit geschmolzenem Kristallrohmaterial eingetaucht und langsam vorzugsweise unter Rotation herausgezogen. Dabei wächst beim Herausziehen ein größerer Kristall an.

Dieses Verfahren hat zum Nachteil, daß durch die Kühlung am Kristall relativ große Temperaturänderungen erzeugt werden, die zu einer spannungsinduzierten Anisotropie führen.

Beim vertikalen Bridgman-Verfahren wird in einem beweglichen Schmelztiegel ein Kristallrohmaterial mittels einem Heizmantel aufgeschmolzen, wobei dann der Tiegel in einem durch die Heizung aufgebauten axialen Temperaturgradienten aus dem Heizmantel heraus langsam nach unten abgesenkt wird, oder es wird alternativ bei feststehendem Tiegel eine bewegliche Heizeinrichtung nach oben verschoben, wobei sich die Schmelze abkühlt und ein zugesetzter Kristallkeim langsam wächst. In einer Variante hierzu, dem sogenannten Bridgman-Stockbager-Verfahren wird der bewegbare Tiegel in einem axialen Gradienten zwischen zwei übereinander angeordneten Heizmänteln, zwischen denen eine scharfe Temperaturstufe ausgebildet ist, unter Bildung eines Kristalles langsam abgesenkt.

Beim sogenannten Vertical Gradient Freeze-Verfahren (VGF-Verfahren) werden um den feststehenden Schmelztiegel herum mehrere übereinander liegende konzentrische Heizkreise mantelförmig angeordnet. Jeder dieser Heizkreise läßt sich getrennt ansteuern. Durch ein langsames Herunterfahren der Heizleistung jedes einzelnen um die Tiegelwand angeordneten Heizkreises läßt sich die Temperatur langsam unter den Kristallisationspunkt herabfahren, wodurch ein radialer Temperaturgradient entsteht, entlang dessen das Kristallwachstum stattfindet.

Bei der sogenannten Gradient-Solidification-Method (GSM) wird um einen feststehenden Schmelztiegel ein diesen ringförmig umgebender Heizkreis langsam herunter und wieder hoch gefahren.

Orientierte Einkristalle zeigen üblicherweise trotz allem keine homogene optische und mechanische Eigenschaften. Es ist wünschenswert, derartige Kristalle mit einer für den jeweiligen Gebrauchszweck geeigneten Kristallorientierung auszubilden. Dies wirft jedoch bei der Herstellung von großen Einkristallen besondere Probleme auf, da diese bei ihrer Zucht spontan die Orientierung, d.h. die Lage der Kristallachse ändern, was zu optisch inhomogenen Kristallen führt, bei denen die Lichtbrechung nicht in allen Bereichen gleich ist.

Bislang war es zwar möglich Kristalle herzustellen, welche einzelne dieser Eigenschaften aufweisen, jedoch war es bislang nicht möglich, großvolumige einheitlich orientierte Kristalle zu züchten, die frei von Konvergenzen sind, die optisch hoch homogen sind, eine hohe Transmission aufweisen und sich zudem bei Belichtung mit einer starken Strahlungsquelle nicht verfärben.

Bei den bisherig bekannten Vorgehensweisen, beispielsweise bei der Herstellung von großen Calciumfluorid-Einkristallen, wurde versucht den Kristall in Richtung der {111}-Achse zu züchten, jedoch war dabei die Ausbeute sehr gering, d.h. nur ca. 6-8 % der Züchtungsvorgänge führte zur befriedigenden Größe. Da es sich bei derartigen Kristallzüchtungsverfahren um einen Prozess mit ca. 6-wöchiger Laufzeit handelt, und die Anzahl derartiger Züchtungsanlagen aus Kostengründen beschränkt ist, entstand lediglich eine geringe Ausbeute. Zudem war es mit den bisherigen Verfahren nicht möglich, großvolumige, insbesondere sich weit in alle drei Raumrichtungen erstreckende Einkristalle, d.h. vorzugsweise runde Kristalle mit einem Durchmesser von > 200 mm und einer Höhe von > 100 mm herzustellen, da sich bei solchen Dimensionen innerhalb des Kristallvolumens regelmäßig Blöcke ausbilden, d.h. es kam zu einer Umorientierung der Kristallachsen. Darüber hinaus ist es bislang nicht gelungen, derartig große Kristalle in zufriedenstellender Weise auch optisch hoch homogen zu gestalten, d.h. dass die Lichtbrechung in allen Bereich gleich ist. Ein weiteres Problem für derartige Kristalle ist die Strahlungsfestigkeit, d.h. dass diese sich bei Belichtung mit einer starken Strahlungsquelle wie beispielsweise einem Laser nicht verfärben, was beispielsweise bei der großtechnischen Herstellung von Wafern zu einer Verringerung der Ausbeute führt.

M. Althaus et al. beschreiben in JOURNAL OF CRYSTAL GROWTH (1996) Seiten 566-571, dass mittels einer konkaven Wachstumsfront Störungen in den Kristall hineinwachsen, wohingegen bei einer leicht konvexen Wachstumsfront diese Störungen aus dem Kristall herauswachsen, wo sie an der äußeren Kristallwand enden.

In der JP 11-079880 A wird die Herstellung von Fluorid-Kristallen mittels dem Bridgman-Verfahren beschrieben. Dabei wird ein oberer bzw. unterer Heizer verwendet, wobei die Tiegelseiten zur Vermeidung eines radialen Wärmeflusses abisoliert sind.

Es ist auch bereits versucht worden, große Einkristalle dadurch herzustellen, dass diese in Form von Platten gezüchtet werden. So beschreibt beispielsweise die EP-A-0 338 411 eine Vorrichtung und ein Verfahren zum kontrollierten Wachstum von großen Einkristallen in Plattenform aus einer Schmelze, bei der ein Schmelztiegel mit einem rechteckigen Querschnitt derart ausgestaltet ist, dass dieser zwei verhältnismäßig breite und zwei verhältnismäßig schmale Seitenwände aufweist und wobei unmittelbar eng an die breiten Seiten Heizeinrichtungen angeordnet sind. Dabei wird nach dem Aufschmelzen der Tiegel mittels eines Aufzugs langsam aus dem Heizmantel abgesenkt, wodurch sich dessen Inhalt abkühlt und auskristallisiert. Mit diesem Verfahren ist es zwar möglich große orientierte Einkristallplatten herzustellen, diese weisen jedoch keine ausreichende Ausdehnung in alle drei Raumrichtungen auf.

Die Erfindung hat daher zum Ziel, derartige großvolumige Kristalle bereitzustellen, die in einer beliebig gewählten Einstellung entlang ihrer {h,k,l-Achsen} vorzugsweise in der {111} oder {112}-Orientierung gezüchtet sind.

Die Erfindung hat weiterhin zum Ziel, derartige großvolumige Kristalle bereitzustellen, die sich weit in alle drei Raumrichtungen erstrecken.

Dieses Ziel wird erfindungsgemäss mit dem in den Ansprüchen definierten Verfahren und der zugehörigen Vorrichtung erreicht.

Es wurde nämlich überraschenderweise gefunden, dass sich großvolumige Kristalle dadurch herstellen lassen, dass man diese mit einem axial d.h. parallel zur Wachstumsrichtung verlaufenden Temperaturgradienten bzw. einem axial verlaufenden Wärmefluss abkühlen läßt und dabei einen hierzu senkrecht verlaufenden radialen seitlichen Wärmefluss vermeidet. Dabei wird eine möglichst ebene Grenzfläche zwischen fester kristalliner und geschmolzener flüssiger Phase ausgebildet. Im Gegensatz dazu wird bei den Züchtungsverfahren gemäss dem Stand der Technik überwiegend ein seitlicher radialer Wärmefluss erzeugt, entweder als alleinige Wärmezu- bzw. Wärmeabfuhr oder zusammen mit oberhalb und unterhalb eines Schmelztiegels angeordneter Heizelemente.

Eine erfindungsgemässe Vorrichtung zum Züchten von großvolumigen Einkristallen umfasst ein verschließbares Gehäuse, ein darin angeordnetes Schmelzgefäß sowie mindestens ein Heizelement mit einer Heizleistung, die ausreicht um das im Schmelzgefäß vorliegende Kristallrohmaterial aufzuschmelzen und/oder bereits geschmolzene Kristallrohmasse im geschmolzenen Zustand zu halten.

Das Schmelzgefäß ist vorzugsweise rundförmig. In besonderen Fällen kann es jedoch auch zweckmäßig sein, dass das Schmelzgefäß einen ovalen oder viereckigen Querschnitt aufweist. Das Schmelzgefäß umfasst einen inneren Aufnahmeraum, bzw. Schmelzraum der gebildet wird aus dem Schmelzgefäßboden, seitlichen Wänden und einer dem Boden gegenüberliegenden oberen Öffnung.

In einer besonderen Ausführungsform ist die dem Boden gegenüberliegende obere Öffnung mittels einer Abdeckung verschlossen. Dabei ist die Abdeckung vorzugsweise derart ausgestaltet, dass sie nicht gasdicht auf den Seitenwänden aufliegt, sondern beim Aufschmelzen entstehende abdampfende Verunreinigungen aus dem Schmelz- bzw. Kristallraum austreten läßt. Um den Schmelztiegel herum ist seitlich mindestens ein vorzugsweise mehrere Elemente angeordnet, die einen radialen seitlichen Wärmefluss verhindern. Dies sind insbesonders seitliche Wärmeisolatoren, zweckmäßigerweise solche aus wärmedämmendem Material. Die erfindungsgemäße Vorrichtung weist insbesonders eine seitlich vom Schmelztiegel beabstandete Stützheizung auf, welche ebenfalls einen seitlichen Wärmefluss verhindern soll. Zweckmäßigerweise ist diese Stützheizung in einem Abstand vom Schmelzgefäß angeordnet, der ausreicht damit deren erzeugte Wärme keinen direkten Einfluss auf die Vorgänge in der Schmelze ausüben kann. Die Stützheizung dient lediglich dazu eventuelle, zwischen dem Schmelztiegel sowie den ihn umgebenden, wärmeflussverhindernden Elementen und der Umgebung auftretenden Temperaturgradienten auszugleichen. Er ist daher üblicherweise von den Wänden des Schmelztiegels durch eine dazwischen liegende Schicht aus Wärmeisolationselementen beabstandet. Vorzugsweise ist die Stützheizung als Mantelheizung ausgebildet.

Der Boden des Schmelzgefäßes kann beliebig ausgestaltet sein. Üblicherweise ist er jedoch konusförmig abgesenkt. Er bildet dabei eine Pyramide oder vorzugsweise einen Kegel aus, wobei stumpfförmige Pyramiden oder Kegel besonders bevorzugt sind.

Der Tiegelboden weist eine nach unten austretende Tasche auf, die der Aufnahme eines Impf- oder Keimkristalles mit vorgegebener Orientierung dient. Die Keimtasche ist vorzugsweise in der Mitte des Bodens, d.h. an der Kegel- oder Pyramidenspitze angeordnet. In einer bevorzugten Ausführungsform weist die Keimtasche an ihrem unteren Ende ein Kühlelement auf. Dieses Kühlelement ist ein mit Wasser gekühlter Grafitstab, der den in der Keimtasche vorliegenden Impfkristall davor schützt, beim Schmelzen des Kristallrohmaterials vorzeitig an- oder aufgeschmolzen zu werden. Zweckmäßigerweise ist das Kühlelement beheizbar.

In einer bevorzugten Ausführungsform weist der Schmelztiegel einen oberhalb des Schmelzraumes angeordneten erweiterten Pufferraum auf, der als Trichter zum Einfüllen des Kristallrohmaterials dient. Insbesondere dient er jedoch dazu, die von einer Deckelheizung abgegebene Wärmemenge zu equilibrieren, damit ein auf die Kristallmasse gleichmäßig einwirkender Wärmefluss erzeugt wird und eventuell an der Heizung entstehende lokale Temperaturunterschiede ausgeglichen werden. Vorzugsweise ist der eigentliche Schmelzraum mit einer wärmeleitenden Abdeckung versehen, die den Isolationsraum und den eigentlichen Schmelzraum trennt. Sie dient ebenso der Temperaturequilibrierung und besteht aus einem nur leicht wärmedämmendem bzw. isolierendem Material.

Die erfindungsgemäße Vorrichtung weist nun mindestens ein oberhalb des Schmelzgefäßes angeordnetes Heizelement auf.

Aufgrund des das Schmelzgefäß umgebenden, einen seitlichen Wärmefluss verhindernden Isolationselementes, entsteht durch Aufheizen dieses oberhalb des Schmelzgefäßes angeordneten Heizelementes, ein im Schmelzgefäß ausschließlich axial verlaufender Wärmefluss. Ein seitlicher Wärmefluss wird durch die Isolationselemente verhindert. Dieses obere Heizelement ist zweckmäßigerweise eine Deckelheizung.

Es hat sich als vorteilhaft erwiesen, zusätzlich zur Deckelheizung am Schmelzgefäßboden eine Bodenheizung anzubringen. Dabei läßt sich zwischen Deckelheizung und Bodenheizung ein noch besserer axialer Wärmefluß bzw. Temperaturgradient aufbauen, der besonders fein justierbar ist.

Zweckmäßigerweise wird dabei die Bodenheizung derart unterhalb des Schmelzgefäßbodens angeordnet, dass diese die Keimtasche nicht mit einschließt oder zumindest gegenüber dieser isolierend beabstandet ist, um ein vorzeitiges ungewolltes Aufschmelzen des Kristallkeimes/Impfkristalles zu vermeiden.

In einer bevorzugten Ausführungsform sind sämtliche Heizelemente in eine das Schmelzgefäß umgebende Umhüllung aus Isolationsmaterial mit eingeschlossen, um auf diese Weise einen ungewollten und unkontrollierten Wärmefluss zu vermeiden.

Es hat sich als zweckmäßig erwiesen an der Außenwand des Schmelzgefäßes möglichst ohne Abstand eng verlaufend ein oder mehrere Temperaturmesselemente anzuordnen. Vorzugsweise ist/sind das oder die Messelemente als Schiebeelement ausgebildet, welche von außen bei Betrieb der Vorrichtung längs der Seitenwand verschiebbar angebracht sind um so den vom Gefäßboden zum Gefäßdeckel axial verlaufenden Temperaturgradienten zu messen. Bevorzugte Messelemente sind Thermoelemente, Thermistoren und insbesondere Pyrometer.

In einer besonders bevorzugten Ausführungsform weist die erfindungsgemässe Vorrichtung eine Einrichtung auf, mit der die Grenze zwischen fester kristalliner und geschmolzener flüssiger Phase bestimmt werden kann. Als zweckmäßig hat sich hierfür ein Phasentaster erwiesen, der einen in einem hohlen Führungsrohr verlaufenden Taststab umfasst, welcher in das Schmelzgefäß reicht und wobei der Stab im Führungsrohr langsam nach unten abgesenkt werden kann, wobei die feste kristalline Phase ertastet wird. In einer anderen bevorzugten Ausführungsform besteht der Phasentaster aus einem Ultraschallgerät, welches von oben in die Schmelze eintaucht und die an der Phasengrenzfläche reflektierten Schallwellen misst und auf diese Weise das Kristallwachstum bestimmt.

In einer weiteren erfindungsgemässen Ausführungsform weist die Vorrichtung einen oberhalb der Öffnung des Schmelztiegels angeordneten Kondensator auf, der eventuell austretende Materialdämpfe abscheidet. In einer weiteren bevorzugten Ausführungsform umfasst das Gehäuse der erfindungsgemässen Vorrichtung einen verschließ- und öffenbaren Deckel, über den das Schmelzgefäß mit Kristallrohmaterial beschickt werden und der fertige Kristall entnommen werden kann. Vorzugsweise weist das Gehäuse der Vorrichtung mindestens eine Öffnung zum Be- oder Entlüften des gesamten Innenraums auf. Über diese Öffnung kann das Innere der Vorrichtung unter Vakuum gesetzt und/oder ggf. mit einem Schutzgas gefüllt werden.

Die innerhalb des Gehäuses angeordneten Elemente der erfindungsgemässen Vorrichtung bestehen vorzugsweise aus Grafit. Dabei wird das Schmelzgefäß aus einem gut wärmeleitenden gepressten Grafit gebildet. Das Isolationsmaterial besteht vorzugsweise aus einem lose gepackten Grafit, insbesondere Faserwerkstoffen aus Grafitwolle oder Grafitmatten. Auch die Heizelemente sind zweckmäßigerweise aus Grafit gebildet, wobei sich wärmeerzeugende, stromleitende Grafitbahnen mäanderförmig um die zu beheizende Fläche winden und als Stromwiderstandsheizung Wärme erzeugen. Zur Vermeidung von Kurzschlüssen werden die stromführenden Elemente von den benachbarten Grafitteilen mittels Isolatoren in Abstand gehalten. Bevorzugte Isolatoren sind hierbei Bornitrid.

Das Gehäuse der erfindungsgemässen Anlage besteht üblicherweise aus einem chemisch resistenten, hitzebeständigen Material und ist vorzugsweise eine Stahllegierung, wobei Edelstahl besonders bevorzugt ist. Allerdings hat sich in vielen Fällen auch Baustahl als ausreichend erwiesen.

Die Erfindung betrifft auch ein Verfahren zur Herstellung von großvolumigen Einkristallen. Dabei wird erfindungsgemäss derart vorgegangen, dass man eine Kristallrohmasse in einem Gefäß aufschmilzt, das einen Boden, seitliche Wände, eine obere Öffnung sowie gegebenenfalls eine die obere Öffnung zumindest teilweise verschließende Abdeckung aufweist. Prinzipiell ist es auch möglich, die Kristallrohmasse bereits im geschmolzenen Zustand in das Schmelzgefäß einzuführen.

Zur Herstellung von großvolumigen Einkristallen wird nun erfindungsgemäss derart vorgegangen, dass man die Schmelze ausgehend vom Tiegelboden langsam in Richtung Schmelzoberfläche bzw. einer über der Schmelzoberfläche angeordneten Deckelheizung langsam abkühlt, wobei sich am Gefäßboden ein Kristallkeim ausbildet, der dann entlang des Temperaturgradienten bzw. entlang der Wärmeflussachse wächst. Dabei wird erfindungsgemäss derart vorgegangen, dass ausschließlich ein Wärmefluss bzw. Temperaturgradient zwischen dem Gefäßboden und der Schmelzoberfläche bzw. der Abdeckung oder Deckelheizung ausgebildet wird. Dies bedeutet, dass im Schmelztiegel übereinander liegende Temperaturflächen gebildet werden die eben sind, wobei die Temperatur vom Tiegelboden bis zur Oberfläche der Schmelze bzw. Deckelheizung zunimmt, wobei innerhalb einer Temperaturfläche bzw. Temperaturebene an allen Punkten die Temperatur gleich ist, d.h. dass sie um maximal 2°C variiert. Vorzugsweise ist die Temperaturzunahme zwischen Gefäßboden und der Oberfläche der Schmelze kontinuierlich. Sofern die Flächen, in denen die Temperatur gleich ist, eine minimale Wölbung aufweisen, dann ist deren Radius ≧ 1 m. Besonders bevorzugt sind Radien > 2 m, wobei Radien > 4 m besonders bevorzugt sind.

Auf diese Weise entsteht eine Phasengrenzfläche zwischen der festen kristallinen und der flüssigen geschmolzenen Phase, die sich entlang dem Temperaturprofil, d.h. parallel zu den Ebenen gleicher Temperatur ausbildet und die senkrecht zu diesen Ebenen wächst.

Die für die erfindungsgemässe Kristallzüchtung notwendige ebene Phasengrenzfläche wird dadurch erreicht, dass man einen seitlichen, d.h. radialen Wärmefluss vermeidet. Dies wird mittels seitlicher insbesondere um die Wände des Schmelzgefäßes angeordneter Elemente erreicht. Derartige Elemente sind vorzugsweise eine Stützheizung und/oder ein Isolationsmaterial. Besonders bevorzugt ist es entlang der Seitenwände beabstandete Heizelemente anzuordnen, die ausschließlich der Temperaturstützung dienen. Dabei ist der zwischen Schmelzgefäß und beabstandeter Heizung, die vorzugsweise als Mantelheizung ausgebildet ist, entstehende Zwischenraum mit Isolationsmaterial gefüllt, welches einerseits einen seitlichen Wärmeabfluss und damit die Ausbildung eines radialen Temperaturgradienten verhindert und welches andererseits verhindert, dass die Stützheizung lokale Überhitzungen im Schmelzgefäß erzeugt. Die Stützheizung dient im wesentlichen dazu, eventuellen durch den Isolationsmantel durchtretenden Wärmeverlusten entgegenzuwirken und unterstützt so die radiale Einebnung des Temperaturprofils.

Prinzipiell ist es möglich den im erfindungsgemässen Verfahren erzeugten axialen Wärmefluss ausschließlich durch eine oberhalb des Tiegels angeordnete Deckelheizung auszubilden. Es ist jedoch bevorzugt auch den Tiegelboden mittels einer Bodenheizung aufzuheizen, so dass ein Temperaturgradient zwischen Deckel- und Bodenheizung ausgebildet wird.

Erfindungsgemäss ist es bevorzugt, das Kristallwachstum mittels einem am Boden des Schmelzgefäßes vorliegenden Keimkristall zu fördern. Der Keimkristall ist vorzugsweise ein Einkristall, der in eine an dem Gefäßboden anhängenden Keimtasche eingeführt wird, und zwar vorzugsweise so, dass seine Orientierung der gewünschten späteren Orientierung des großvolumigen Einkristalls entspricht. Beim Aufschmelzen wird dann derart vorgegangen, dass durch ein Anheizen der Deckelheizung und vorzugsweise der Bodenheizung das im Gefäß vorliegende Kristallrohmaterial aufgeschmolzen wird. Gegebenenfalls wird hier zur Unterstützung auch der Mantelheizer eingesetzt. Dabei wird der Tiegel vorzugsweise auf eine Temperatur erwärmt, bei der zuerst eventuelles Kristallwasser freigesetzt wird. Danach wird die Temperatur weiter erhöht, wobei gegebenenfalls gelöste Gase oder in der Kristallrohmasse gebundene gasförmige Teile, sowie durch beim Erwärmen entstandene gasförmige Zersetzungsprodukte, freigesetzt werden.

Dann wird über einen längeren Zeitraum hinweg vorzugsweise mindestens einen Tag die Schmelz homogenisiert. Dies wird insbesondere dadurch erreicht, dass die Heizleistung der Heizelemente derart eingestellt wird, dass in der Schmelze eine Konvektion entsteht, wodurch diese laufend vermischt wird, so dass gelöste und unerwünschte Verunreinigungen an die Schmelzoberfläche gelangen, wo insbesondere recht flüchtige Substanzen abdampfen können. Dabei ebenfalls mit abgedampftes Kristallmaterial wird in einem vorzugsweise gekühlten Kondensator abgeschieden. Vorzugsweise wird die Homogenisierung der Schmelze mindestens zwei Tage, insbesondere jedoch mindestens fünf Tage durchgeführt, wobei mindestens eine Woche ganz besonders bevorzugt ist.

Während des Aufschmelzens und während der Homogenisierung wird der in der Keimtasche vorliegende Kristallkeim vorzugsweise gekühlt, um ein vorzeitiges Auf- oder Anschmelzen zu vermeiden. Dies geschieht üblicherweise mittels einer Wasserkühlung. Die Kühlung wird zweckmäßigerweise mittels eines mit Wasser gekühlten Grafitstabes durchgeführt.

Nach Ende des Aufschmelzens und der Homogenisierung der Schmelze wird der Kristallkeim vorsichtig angeschmolzen. Dies geschieht normalerweise dadurch, dass die Kühlleistung verringert wird und/oder eine Keimtaschenheizung angestellt wird. Dabei wird der Keimkristall vorsichtig von oben nach unten angeschmolzen, so dass ein gleichförmiger Übergang zwischen Kristallkeim und der Schmelze entsteht. Danach wird der axiale Temperaturgradient dadurch ausgebildet, dass entweder die Heizleistung der Deckelheizung und/oder der Bodenheizung langsam erniedrigt wird. Vorzugsweise wird jedoch so vorgegangen, dass die Deckenheizung auf eine Temperatur eingestellt wird, die gleich ist oder oberhalb, vorzugsweise geringfügig oberhalb der Kristallisationstemperatur des herzustellenden Kristalls liegt. Zweckmäßige Deckelheiztemperaturen liegen 200-300°C oberhalb der Kristallisationstemperatur. Die Temperatur der Bodenheizung beträgt zweckmäßigerweise mindestens 650°C vorzugsweise mindestens 900°C, ist jedoch bei der Kristallzucht tiefer als die Schmelztemperatur. Danach wird die Heizleistung der Bodenheizung langsam abgesenkt. Durch das Herabfahren der Bodenheizung auf eine Temperatur unterhalb der Kristallisationstemperatur kühlt die Schmelze entlang des axialen Temperaturgradienten langsam ab, wobei sich die Phasengrenzfläche, welche sich an der Ebene der Kristallisationstemperatur ausbildet, im Schmelzgefäß langsam von oben nach unten verschiebt, wodurch der Kristall wächst. Prinzipiell ist es auch möglich, die Temperatur der Deckelheizung herunterzufahren. Dabei wird die Temperatur mit einer Geschwindigkeit heruntergefahren, bei der das Kristallwachstum 0,01 bis 5 mm/Stunde, vorzugsweise 0,1 bis 1 mm/Stunde und insbesondere 0,2 bis 0,5 mm/Stunde beträgt. Diese Werte werden üblicherweise mit einer Abkühlgeschwindigkeit von 0,001 bis 5°C pro Stunde erreicht.

Es hat sich als vorteilhaft erwiesen, wenn die Temperatur in der bereits auskristallisierten Phase, d.h. im gewachsenen Kristall, während des Züchtungsprozesses nicht diejenige Temperaturschwelle unterschreitet, bei der noch eine plastische Form erfolgt. Hinter der Phasengrenze soll daher ein möglichst flacher axialer Temperaturgradient erfolgen.

Erfindungsgemäß hat es sich als zweckmäßig erwiesen, im unteren konusförmigen Bodenteil des Schmelztiegels, d.h. in dem Teil, der zwischen der Keimtasche und der Tiegelwand den Boden bildet, zu Beginn der Kristallzucht eine nicht ebene nach oben zum Deckel gewölbte Phasengrenzfläche auszubilden, die einen Radius < 1 m, vorzugsweise < 0,8 m, insbesondere < 0,5 m aufweist.

Nach Fertigstellung des Einkristalles wird der so erhaltene Kristall getempert. Dabei werden eventuell vorliegende Kristallinhnmoaenitäten bei erhöhter Temperatur ausgeglichen, d.h. Kristalldefekte werden bei dieser Temperatur ausgeheilt. Nach der Kristallzucht und dem Tempern wird der gesamte großvolumige Einkristall langsam auf Raumtemperatur abgekühlt. Eine derartige Abkühlung wird üblicherweise über mehrere Tage bis mehrere Wochen hinweg durchgeführt und zwar je nach Phase und Stufe vorzugsweise mit einer Abkühlgeschwindigkeit von ca. 0,001°C/Stunde bis 15°C/Stunde, insbesondere bis 10°C/Stunde und zweckmäßigerweise bis 1°C/Stunde, wobei 0,01°C/Stunde bis 8°C/Stunde, insbesondere 3°C/Stunde bevorzugt ist. Auch beim Abkühlen wird vorzugsweise ein im wesentlichen axialer Temperaturgradient beibehalten. Allerdings kann hierbei auf die seitliche Stützheizung ggf. verzichtet werden. Durch ein derart langsames Abkühlen werden großvolumige Kristalle erhalten, die eine außergewöhnlich hohe Stressfreiheit aufweisen. Die Abkühlungsrate wird vorzugsweise mittels mehrerer in der erfindungsgemässen Vorrichtung angeordneter Temperaturfühler kontrolliert. Auf diese Weise läßt sich der Temperaturverlauf der Abkühlung auch regeln, was ebenso wie bei der Kristallzüchtung zweckmäßigerweise mittels einem Computer durchgeführt wird.

Der im erfindungsgemässen Verfahren eingesetzte Kristallrohstoff umfasst insbesondere Rohstoffe, welche neben dem Kristallmaterial auch Scavenger enthalten, die in einer Homogenisierungsphase mit eventuell vorliegenden Verunreinigungen zu leicht flüchtigen Substanzen reagieren. Derartige Kristallmaterialien sind MgF₂, BaF₂, SrF₂, LiF und NaF, wobei CaF₂ besonders bevorzugt ist. Mit dem erfindungsgemässen Verfahren werden großvolumige Einkristalle erhalten, welche einen Durchmesser von mindestens 200 mm vorzugsweise mindestens 250 mm und insbesondere mindestens 300 mm sowie eine Höhe von mindestens 100 mm vorzugsweise 130 mm und insbesondere mindestens 140 mm aufweisen. Die dabei erhaltene optische Homogenität über das gesamte Kristallvolumen ist dabei äußerst groß, d.h. dass die maximale Änderung der Brechzahl der Lichtbrechung über das Kristallvolumen hinweg einen maximalen Unterschied von δn ≦ 3 x 10⁻⁶ vorzugsweise ≦ 2 x 10⁻⁶ insbesondere ≦ 1 x 10⁻⁶ aufweist und die Spannungsdoppelbrechung SDB < 3 nm/cm insbesondere < 2 nm/cm insbesondere < 1 nm/cm beträgt.

Das erfindungsgemässe Verfahren wird vorzugsweise in einem Vakuum zwischen 10⁻³ bis 10⁻⁶ mbar (entsprechend 10⁻¹ bis 10⁻⁴ Pa) und vorzugsweise zwischen 10⁻⁴ und 10⁻⁵ mbar (10⁻² bis 10⁻³ Pa) durchgeführt. Besonders bevorzugt ist es, das erfindungsgemässe Verfahren in einer Schutzgasatmosphäre, insbesondere einer nicht oxidierenden Atmosphäre durchzuführen. Dabei wird die gesamte erfindungsgemässe Apparatur vor oder auch während des Aufheizens mit einem Inertgas oder einer Inertgasmischung gespült.

Bei der Durchführung des erfindungsgemässen Verfahrens wird die erfindungsgemässe Vorrichtung vorzugsweise erschütterungsfrei gelagert. Das Schmelzgefäß und die Heizelemente sind während des Betriebes fest und unveränderbar zueinander gelagert.

Die mit dem erfindungsgemässen Verfahren erhaltenen großvolumigen Kristalle eignen sich besonders zur Herstellung von optischen Komponenten für die DUV-Lithographie sowie zur Herstellung von mit Photolack beschichteten Wafern und somit zur Herstellung von elektronischen Geräten. Die mittels dem erfindungsgemässen Verfahren und/oder in der erfindungsgemässen Vorrichtung hergestellten Einkristalle werden zur Herstellung von Linsen, Prismen, Lichtleitstäben, optischen Fenstern sowie optischen Geräten für die DUV-Lithographie insbesondere zur Herstellung von Steppern und Excimerlasern und somit auch zur Herstellung von integrierten Schaltungen sowie elektronischer Geräte wie Computerchips enthaltenden Computern sowie andere elektronische Geräte, welche chipartige integrierte Schaltungen enthalten, verwendet.

Die Erfindung soll anhand der folgenden Figuren und des Beispiels näher erläutert werden. Es zeigen
- Figur 1: eine erfindungsgemässe Vorrichtung zur Züchtung von großvolumigen Kristallen,

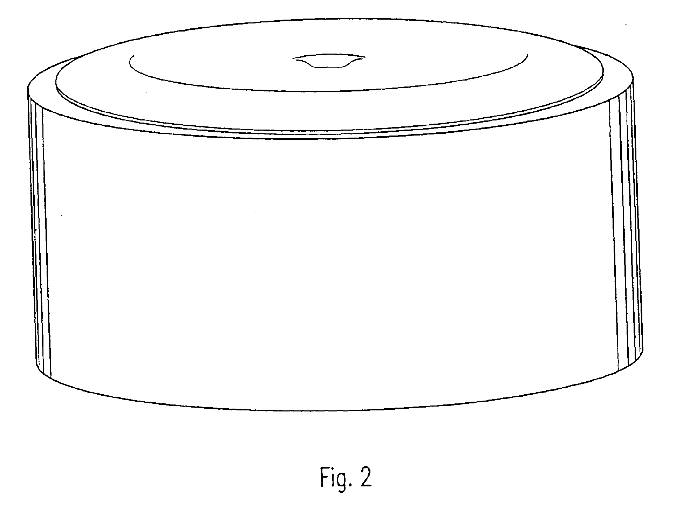

- Figur 2: ein mit dieser Vorrichtung hergestellter Einkristall mit einem Durchmesser von 385 mm sowie einer Höhe von ca. 160 mm.

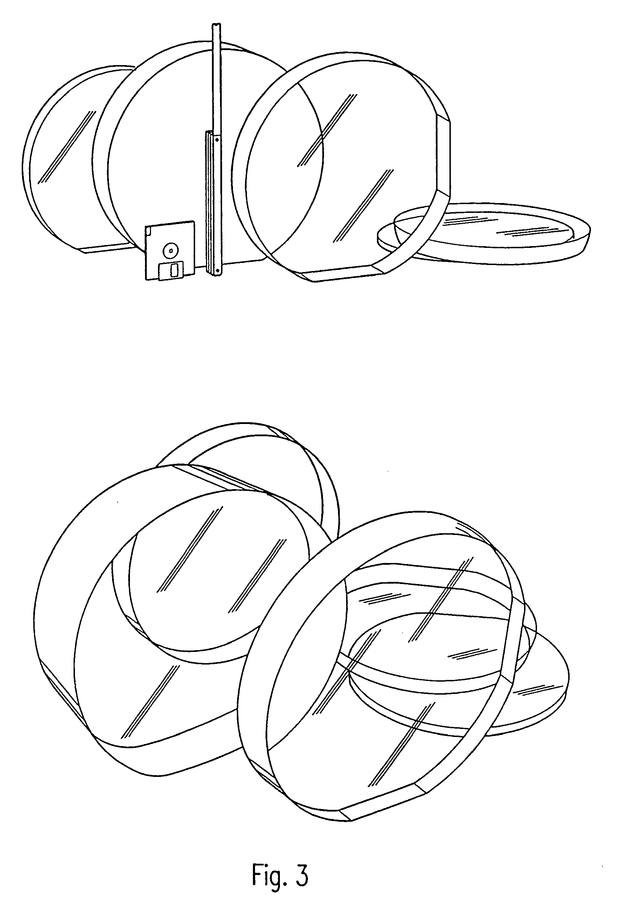

- Figur 3: zeigt Einkristallscheiben, welche aus dem Einkristall von Figur 2 hergestellt wurden.

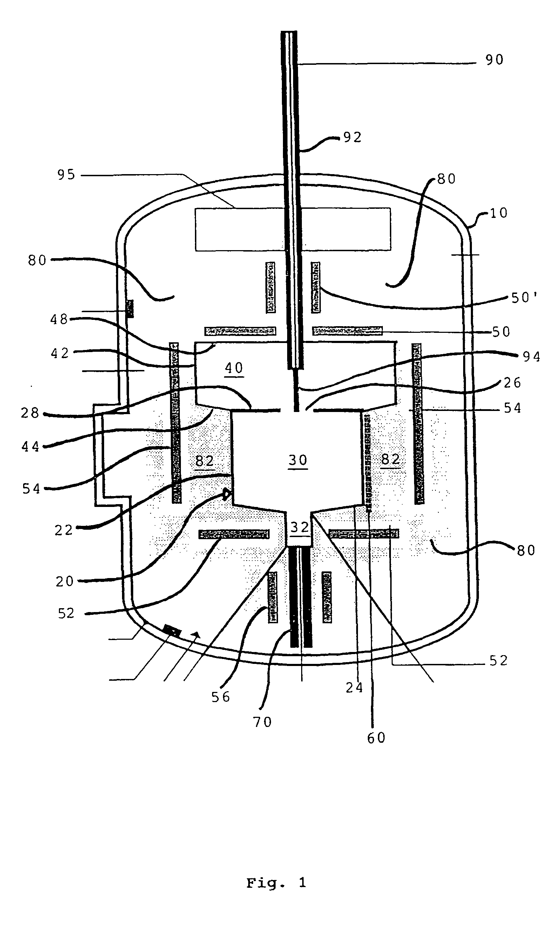

Wie in Fig. 1 dargestellt, umfasst die erfindungsgemässe Vorrichtung ein insbesonders doppelwandig ausgebildetes Gehäuse 10, in dem der aus gepresstem Grafit gebildete Schmelztiegel 20 angeordnet ist. Der Schmelztiegel 20 weist einen Innenraum 30 (Schmelz- bzw. Kristallisationsraum) auf, der durch Wände 22, einem in Form eines stumpfen Kegels ausgebildeten konusförmig verlaufenden Boden 24 sowie einer oberen Tiegelöffnung 26 gebildet wird, welche mittels einer Abdeckung 28 teilweise verschlossen ist. Im oberen Teil des Schmelztiegels ist ein trichterförmiger Pufferraum 40 angeordnet, der aus dem gleichen Material wie der Schmelztiegel 20 gebildet und mit diesem vorzugsweise einstückig verbunden ist. Der Pufferraum 40 selbst weist ebenfalls Seitenwände 42, eine Abdeckung 48 sowie einen Boden 44 auf, der mit den Seitenwänden 22 des Schmelzgefäßes 20 verbunden ist. Oberhalb des Pufferraums 40 ist eine Deckelheizung 50, 50' angeordnet, welche einer Bodenheizung 52 gegenüberliegt. Die Bodenheizung 52 ist seitlich der Keimtasche 32 angeordnet und von dieser in Abstand gehalten, damit der darin vorliegende Keimkristall nicht vorzeitig aufschmilzt. Am Boden enthält die Keimtasche einen wassergekühlten Grafitstab 70. Seitlich der Keimtasche und des wassergekühlten Grafitstabes 70 sind seitliche Heizelemente 56 zum gezielten Anschmelzen des Keimkristalls angeordnet. Darüber hinaus ist seitlich vom Schmelztiegel 20 ein als Schiebelement ausgebildetes Temperaturmesselement 60 angeordnet, mit dem der genaue axiale Temperaturverlauf bestimmt werden kann.

Die Seitenwände 22 des Gefäßes 20 sind vollständig von einem Isolationsmantel 82 umgeben. Der Isolationsmantel 82 beabstandet eine seitliche mantelförmige Stützheizung 54. Die Heizelemente 50, 50', 52, 54 und 56 sowie der Schmelztiegel 20 mit Keimtasche 32 und der darüber liegende Pufferteil 40 werden von einem aus Grafit gebildeten Isolationsmaterial 80 umgeben, welches einen seitlichen Wärmefluss verhindert und ausschließlich einen zwischen Deckelheizung und Schmelztiegelboden 24 bzw. Bodenheizung 52 ausgebildeten axialen Temperaturgradienten erlaubt.

Die erfindungsgemässe Vorrichtung weist eine nicht dargestellte Öffnung zum Spülen mit einem Inertgas bzw. zum Anlegen eines Vakuums auf. Zur Bestimmung der Größe des wachsenden Kristalls bzw. der Lage der Phasengrenzfläche ist ein von außen durch das Gehäuse durchreichender Phasentaster 90 vorhanden, welcher einen in einem äußeren Rohr 92 liegenden verschiebbaren Stab 94 enthält, der langsam nach unten absenkbar ist und mit dem die feste Phasengrenzfläche ertastet werden kann. Prinzipiell kann das Rohr 92 auch mit dem Stab 94 verbunden sein. Zum Abscheiden von beim Homogenisieren entfernten Verunreinigungen ist oberhalb des Schmelztiegels ein Kondensator 95 angeordnet.

### Beispiel 1

Es wird zur Herstellung eines Calciumfluorid-Einkristalls der Innenraum 30 des Schmelzgefäßes 20 mit einer Calciumfluoridmischung gefüllt, welche zusätzliches Scavengermaterialien mit einer hohen Affinität zu Sauerstoff, wie PbF₂, SnF₂ oder CdF₂ aufweisen eingefüllt, die Vorrichtung mittels einem in Figur 1 nicht dargestellten Deckel verschlossen und zur Entfernung von unerwünschtem Luftsauerstoff mit Stickstoff als Inertgas gespült. Danach wird ein Vakuum von 10⁻⁴ mbar (10⁻² Pa) angelegt und unter Kühlung der Keimtasche die Deckelheizung 50, 50', die Bodenheizung 52 sowie gegebenenfalls die Mantelheizung 54 angestellt und langsam über mehrere Stunden auf 1450°C aufgeheizt. Danach wird fünf Tage lang bei dieser Temperatur homogenisiert, wobei in der Schmelze eine Konvektion aufrecht erhalten wird. Nach der Homogenisierung wird die Bodenheizung auf eine Temperatur von 1200°C herab gefahren und mittels der Keimtaschenheizung 26 der Keimkristall vorsichtig angeschmolzen. Nach Abstellen der Keimtaschenheizung wird die Deckelheizung 50, 50' konstant gehalten und die Bodenheizung langsam über mehrere Tage hinweg auf eine Temperatur unterhalb des Kristallisationspunktes herunter gefahren, wobei ausgehend vom Kristallkeim ein Einkristall in Richtung der Oberfläche der Schmelze wächst. Der dabei entstehende Einkristall weist die gleiche Orientierung auf wie der Kristallkeim. Nachdem die gesamte Schmelze unter Ausbildung eines Einkristalles erstarrt ist, wird der so erhaltene Einkristall getempert und über einen Zeitraum von drei Wochen auf Raumtemperatur abgekühlt. Auf diese Weise wird ein Einkristall erhalten, der einen Durchmesser von 385 mm und eine Höhe von 161 mm (ohne Keimtasche) aufweist. Der Einkristall weist über das gesamte Kristallvolumen hinweg eine Schwankung der Brechzahl Δn von < 1 x 10⁻⁶ auf. Seine Spannungsdoppelbrechung SDB ist < 1 nm/cm. Darüber hinaus zeigt der so erhaltene Kristall eine außerordentlich hohe Strahlungsbeständigkeit.

## Patentansprüche

1. Vorrichtung zum Züchten von Einkristallen mit einem Durchmesser von mindestens 200 mm und einer Höhe von mindestens 100 mm, umfassend ein Gehäuse (10) mit einer verschließbaren Eintrag- und Entnahmeöffnung, sowie einem darin angeordneten Schmelzgefäß (20), das einen aus einem Boden (24), Seitenwänden (22), einer dem Boden gegenüberliegende obere Öffnung (26) gebildeten Schmelzraum (30) umfasst, der gegebenenfalls eine Abdeckung (28) aufweist,
sowie zumindest ein Heizelement (50, 50') zum Aufschmelzen einer im Schmelzraum (30) vorliegenden Kristallrohmasse und/oder zum Aufrechthalten des geschmolzenen Zustandes einer bereits geschmolzenen Kristallrohmasse,
wobei das Heizelement (50, 50') oberhalb des Schmelzgefäßes (20) angeordnet ist und einen zwischen dem Boden (24) und der Öffnung (26) des Schmelzgefäßes axial verlaufenden Wärmefluss erzeugt,
**dadurch gekennzeichnet, dass** an den Seitenwänden (22) des Schmelztiegels (20) mindestens ein Isolationsmantel (82) und/oder eine Stützheizung (54) angeordnet sind, welche einen seitlichen radialen Wärmefluss verhindert, und dass der Boden (24) des Schmelztiegels (20) eine Keimtasche (32) zur Aufnahme eines Kristallkeimes aufweist, an der ein wassergekühlter Grafitstab (70) als Kühlelement sowie ein Heizelement (56) angeordnet ist.

2. Vorrichtung nach Anspruch 1,
**dadurch gekennzeichnet, dass** die an den Seitenwänden (22) angeordneten Elemente den seitlichen Wärmefluss soweit verhindern, dass beim Kristallwachstum eine ebene Phasengrenzfläche fest/flüssig ausgebildet wird, die einen Krümmungsradius von ≧ 1 m aufweist.

3. Vorrichtung nach einem der vorhergehenden Ansprüche,
**dadurch gekennzeichnet, dass** der Boden (24) des Schmelzgefäßes (20) kegelförmig ausgebildet ist.

4. Vorrichtung nach einem der vorhergehenden Ansprüche,
**dadurch gekennzeichnet, dass** an der Seitenwand (22) des Schmelzgefäßes (20) ein Temperaturmesselement (60) angeordnet ist.

5. Vorrichtung nach einem der vorhergehenden Ansprüche,
**dadurch gekennzeichnet, dass** sie ein Element (90) zum Ertasten der Phasengrenzfläche fest/flüssig umfasst.

6. Vorrichtung nach einem der vorhergehenden Ansprüche,
**dadurch gekennzeichnet, dass** Heizelemente, Isolationsmaterial oder Schmelztiegeln aus Grafit bestehen.

7. Vorrichtung nach einem der vorhergehenden Ansprüche,
**dadurch gekennzeichnet, dass** sie in Abstand von den Schmelzgefäßseitenwänden (22) eine beabstandete Stützheizung enthält.

8. Verfahren zur Züchtung von großvolumigen Einkristallen aus CaF₂, MgF₂, BaF₂, SrF₂, LiF und NaF mit einem Durchmesser von mindestens 200 mm und einer Höhe von mindestens 100 mm, mit einheitlicher Orientierung aus einer Schmelze aus Kristallrohmaterial in einer Vorrichtung umfassend ein verschließbares Gehäuse (10) mit darin angeordneten Seitenwänden (22), einem Boden (24), eine dem Boden (24) gegenüberliegende obere Öffnung (26) sowie gegebenenfalls eine Abdeckung (28) aufweisendes Schmelzgefäß (20),
sowie mindestens ein Heizelement (50, 50'),
wobei ein im Schmelzgefäß (20) vorliegendes Kristallrohmaterial mittels Heizelementen (50, 50') so lange auf eine Temperatur oberhalb des Schmelzpunktes erwärmt wird bis sich eine eine Oberfläche aufweisende Schmelze bildet, und/oder wobei bereits geschmolzenes Kristallrohmaterial in das Schmelzgefäß eingetragen wird, und danach
durch Absenken der Temperatur auf mindestens den Kristallisationspunkt am Boden des Schmelzgefäßes ein Einkristall gebildet wird, der mit der Schmelze eine Phasengrenzfläche fest/flüssig ausbildet, an welcher der Einkristall in eine Richtung senkrecht zur Phasengrenzfläche zur Schmelzoberfläche hinwächst,
**dadurch gekennzeichnet, dass** man bei der Kristallzüchtung eine ebene Phasengrenzfläche erzeugt, indem man zwischen dem Boden (24) des Schmelzgefäßes (20) und dessen oberer Öffnung (26) einen senkrecht verlaufenden axialen Temperaturgradienten anlegt und einen durch die Seitenwände (22) verlaufenden Wärmezu- und/oder Wärmeabfluss vermeidet und dass man mittels eines in einer gekühlten Keimtasche (32) angeordneten Keimkristalles die Wachstumsrichtung vorgibt.

9. Verfahren nach Anspruch 8,
**dadurch gekennzeichnet, dass** man als Wachstumsrichtung die Kristallachse {111} oder {112} verwendet.

10. Verfahren nach einem der vorhergehenden Ansprüche 8-9,
**dadurch gekennzeichnet, dass** man den axialen Temperaturgradienten zwischen einer Bodenheizung (52) und der Dekkelheizung (50, 50') ausbildet.

11. Verfahren nach einem der vorhergehenden Ansprüche 8-10,
**dadurch gekennzeichnet, dass** man durch langsames Absenken der Bodenheizung (52) eine Kristallwachstumsgeschwindigkeit von 0,1 bis 1 mm/Stunde erzeugt.

12. Verfahren nach einem der vorhergehenden Ansprüche 8-11,
**dadurch gekennzeichnet, dass** die Temperatur der Bodenheizung (52) auf höchstens 10°C unterhalb der Schmelztemperatur gehalten wird.

13. Verfahren nach einem der vorhergehenden Ansprüche 8-12,
**dadurch gekennzeichnet, dass** man die Schmelze und/oder den fertigen Kristall mit einer Temperatur zwischen 0,1 bis 5°C pro Tag abkühlt.

14. Verfahren nach einem der vorhergehenden Ansprüche 8-13,
**dadurch gekennzeichnet, dass** man nach dem Einfüllen des Kristallrohmaterials mit einem Inertgas spült und/oder die Züchtung unter Vakuum durchführt.

15. Verfahren nach einem der vorhergehenden Ansprüche 8-14,
**dadurch gekennzeichnet, dass** das man dem Kristallrohmaterial einen oder mehrere Scavenger zusetzt.

16. Verfahren nach einem der vorhergehenden Ansprüche 8-15,
**dadurch gekennzeichnet, dass** man den seitlichen Wärmefluss mittels einer von den Tiegelwänden durch einen Wärmeisolator (82) in Abstand gehaltenen Stützheizung (54) verhindert.

17. Verfahren nach einem der vorhergehenden Ansprüche 8-16,
**dadurch gekennzeichnet, dass** man zu Beginn der Kristallzüchtung die Bodenheizung auf eine Temperatur.von mindestens 650°C und die Deckelheizung auf eine Temperatur von mindestens 1590°C erwärmt.

18. Verfahren nach einem der vorhergehenden Ansprüche 8-17,
**dadurch gekennzeichnet, dass** man die Schmelze vor Beginn der Kristallisation über einen Zeitraum von 1 bis 20 Tagen homogenisiert.

19. Verfahren nach einem der vorhergehenden Ansprüche 8-18,
**dadurch gekennzeichnet, dass** die obere Heizung konstant gehalten wird und man die untere Heizung langsam abkühlt.

## Claims

1. Device for growing single crystals having a diameter of at least 200 mm and a height of at least 100 mm, said device comprising a housing (10) with a closable feed and removal opening, and a melting vessel (20) that is arranged in said housing and comprises a melting chamber (30) that is formed from a bottom (24), side walls (22) and an upper opening (26) situated opposite the bottom and, if appropriate, has a cover (28),
and at least one heating element (50, 50') for melting a crystal raw material present in the melting chamber (30) and/or for maintaining the molten state of a crystal raw material that has already been melted,
wherein the heating element (50, 50') is arranged above the melting vessel (20) and produces a flow of heat that runs axially between the bottom (24) and the opening (26) of the melting vessel,
**characterized in that** at least one insulating jacket (82) and/or a support heater (54) which prevents a lateral, radial flow of heat is arranged on the side walls (22) of the melting crucible (20), and **in that** the bottom (24) of the melting crucible (20) is provided with a seed pocket (32) that is intended to receive a crystal seed and has a water-cooled graphite rod (70), as a cooling element, and a heating element (56) arranged on it.

2. Device according to Claim 1,
**characterized in that** the elements arranged on the side walls (22) prevent the lateral flow of heat to the extent that a planar solid/liquid phase boundary having a radius of curvature of ≥ 1 m is formed during crystal growth.

3. Device according to either of the preceding claims,
**characterized in that** the bottom (24) of the melting vessel (20) has a conical shape.

4. Device according to one of the preceding claims,
**characterized in that** a temperature measuring element (60) is arranged on the side wall (22) of the melting vessel (20).

5. Device according to one of the preceding claims,
**characterized in that** it comprises an element (90) for feeling the shape of the solid/liquid phase boundary.

6. Device according to one of the preceding claims,
**characterized in that** the heating elements, insulating material or melting crucibles consist of graphite.

7. Device according to one of the preceding claims,
**characterized in that** it contains a support heater which is arranged at a distance from the side walls (22) of the melting vessel.

8. Process for growing large-volume single crystals of CaF₂, MgF₂, BaF₂, SrF₂, LiF and NaF that have a diameter of at least 200 mm and a height of at least 100 mm and a uniform orientation from a melt of crystal raw material in a device that comprises a closable housing (10) with a melting vessel (20) that is arranged therein and has side walls (22), a bottom (24), an upper opening (26) situated opposite the bottom (24) and, if appropriate, a cover (28),
and at least one heating element (50, 50'),
wherein heating elements (50, 50') are used to heat a crystal raw material present in the melting vessel (20) at a temperature above the melting point until a molten mass having a surface is formed,
and/or wherein crystal raw material that has already been melted is fed into the melting vessel, and then
a reduction in the temperature to at least the crystallization point forms a single crystal at the bottom of the melting vessel, and this single crystal, together with the molten mass, forms a solid/liquid phase boundary at which the single crystal grows towards the surface of the molten mass, in a direction perpendicular with respect to the phase boundary,
**characterized in that** a planar phase boundary is produced during the crystal growth by applying a vertically running axial temperature gradient between the bottom (24) of the melting vessel (20) and the upper opening (26) thereof and preventing heat from entering and/or leaving through the side walls (22), and **in that** a seed crystal arranged in a cooled seed pocket (32) is used to predefine the direction of growth.

9. Process according to Claim 8,
**characterized in that** the {111} or {112} crystal axis is used as the direction of growth.

10. Process according to either of the preceding Claims 8 and 9,
**characterized in that** the axial temperature gradient is formed between a bottom heater (52) and the top heater (50, 50').

11. Process according to one of the preceding Claims 8-10,
**characterized in that** a crystal growth speed of from 0.1 to 1 mm/hour is produced by slowly lowering the temperature of the bottom heater (52).

12. Process according to one of the preceding Claims 8-11,
**characterized in that** the temperature of the bottom heater (52) is maintained at no more than 10°C below the melting temperature.

13. Process according to one of the preceding Claims 8-12,
**characterized in that** the molten mass and/or the finished crystal is cooled by a temperature of between 0.1 and 5°C per day.

14. Process according to one of the preceding Claims 8-13,
**characterized in that** the introduction of the crystal raw material is followed by purging with an inert gas and/or by growth in vacuo.

15. Process according to one of the preceding Claims 8-14,
**characterized in that** one or more scavengers are added to the crystal raw material.

16. Process according to one of the preceding Claims 8-15,
**characterized in that** a support heater (54) held at a distance from the walls of the crucible by means of a heat insulator (82) is used to prevent the lateral flow of heat.

17. Process according to one of the preceding Claims 8-16,
**characterized in that** the bottom heater is heated to a temperature of at least 650°C and the top heater is heated to a temperature of at least 1590°C at the start of the crystal growth.

18. Process according to one of the preceding Claims 8-17,
**characterized in that** the molten mass is homogenized over a time period of from 1 to 20 days before the start of the crystallization.

19. Process according to one of the preceding Claims 8-18,
**characterized in that** the upper heater is kept at a constant temperature and the lower heater is slowly cooled down.

## Revendications

1. Dispositif de croissance de monocristaux d'un diamètre d'au moins 200 mm et d'une hauteur d'au moins 100 mm, comprenant :
un boîtier (10) doté d'une ouverture refermable d'introduction et de prélèvement et dans lequel est disposé un récipient de fusion (20) qui comporte un espace de fusion (30) formé d'un fond (24), de parois latérales (22), d'une ouverture supérieure (26) située face au fond et éventuellement doté d'un recouvrement (28),
ainsi qu'au moins un élément chauffant (50, 50') qui fait fondre une masse brute de cristal présente dans l'espace de fusion (30) et/ou qui maintient à l'état fondu une masse brute de cristal déjà fondue,
l'élément chauffant (50, 50') étant disposé au-dessus du récipient de fusion (20) et formant un écoulement de chaleur qui s'étend axialement entre le fond (24) et l'ouverture (26) du récipient de fusion,
**caractérisé en ce que**
au moins une enveloppe isolante (82) et/ou un chauffage d'appoint (54) sont disposés sur les parois latérales (22) du creuset de fusion (20) et empêchent un écoulement de chaleur radial latéral et
**en ce que** le fond (24) du creuset de fusion (20) présente une poche (32) destinée à reprendre un germe cristallin sur lequel sont disposés un barreau de graphite (70) refroidi par eau et servant d'élément de refroidissement et un élément chauffant (56).

2. Dispositif selon la revendication 1, **caractérisé en ce que** les éléments disposés sur les parois latérales (22) empêchent suffisamment l'écoulement latéral de chaleur pour que lors de la croissance du cristal il se forme entre la phase solide et la phase liquide une surface frontière plane dont le rayon de courbure est ≥ 1 m.

3. Dispositif selon l'une des revendications précédentes, **caractérisé en ce que** le fond (24) du récipient de fusion (20) a une configuration sphérique.

4. Dispositif selon l'une des revendications précédentes, **caractérisé en ce qu'**un élément (60) de mesure de température est disposé sur la paroi latérale (22) du récipient de fusion (20).

5. Dispositif selon l'une des revendications précédentes, **caractérisé en ce qu'**il présente un élément (90) de palpage de la surface frontière entre la phase solide et la phase liquide.

6. Dispositif selon l'une des revendications précédentes, **caractérisé en ce que** des éléments chauffants, un matériau isolant ou des creusets de fusion sont constitués de graphite.

7. Dispositif selon l'une des revendications précédentes, **caractérisé en ce qu'**il contient un chauffage d'appoint situé à distance des parois latérales (22) du récipient de fusion.

8. Procédé de croissance de monocristaux de grand volume de CaF₂, MgF₂, BaF₂, SrF₂, LiF ou NaF d'un diamètre d'au moins 200 mm et d'une hauteur d'au moins 100 mm, avec orientation unitaire, à partir d'un bain de fusion de matériau brut du cristal, dans un dispositif qui comprend :
un boîtier refermable (10) dans lequel sont disposés des parois latérales (22), un fond (24), une ouverture supérieure (26) située face au fond (24) ainsi qu'un récipient de fusion (20) présentant éventuellement un couvercle (28),
au moins un élément chauffant (50, 50'),
un matériau brut de cristal présent dans le récipient de fusion (20) étant chauffé au moyen d'éléments chauffants (50, 50') à une température supérieure au point de fusion jusqu'à ce qu'il se forme un bain de fusion qui présente une surface et/ou
un matériau brut de cristal déjà fondu est introduit dans le récipient de fusion et ensuite un monocristal est formé au fond du récipient de fusion en abaissant la température au moins jusqu'au point de cristallisation, le monocristal formant avec le bain de fusion une surface frontière entre la phase solide et la phase liquide sur laquelle le monocristal croît dans une direction perpendiculaire à la surface frontière et à la surface de fusion,
**caractérisé en ce que**
lors de la croissance du cristal, on forme une surface frontière plane entre les phases en appliquant entre le fond (24) du récipient de fusion (20) et son ouverture supérieure (26) un gradient axial de température qui s'étend à la verticale et en évitant un apport et/ou une évacuation de chaleur par les parois latérales (22) et
**en ce que** la direction de croissance est définie au moyen d'un germe de cristal disposé dans une poche à germe (32) refroidie.

9. Procédé selon la revendication 8, **caractérisé en ce que** comme direction de croissance, on utilise l'axe cristallin {111} ou {112}.

10. Procédé selon l'une des revendications 8 et 9 qui précèdent, **caractérisé en ce que** l'on forme le gradient axial de température entre un chauffage de fond (52) et le chauffage de couvercle (50, 50').

11. Procédé selon l'une des revendications 8 à 10 qui précèdent, **caractérisé en ce que** l'on forme une vitesse de croissance du cristal de 0,1 à 1 mm/heure par abaissement lent du chauffage de fond (52).

12. Procédé selon l'une des revendications 8 à 11 qui précèdent, **caractérisé en ce que** la température du chauffage de fond (52) est maintenue à au plus 10°C en dessous de la température de fusion.

13. Procédé selon l'une des revendications 8 à 12 qui précèdent, **caractérisé en ce que** le bain de fusion et/ou le cristal terminé sont refroidis à une température comprise entre 0,1 et 5°C par jour.

14. Procédé selon l'une des revendications 8 à 13 qui précèdent, **caractérisé en ce qu'**après avoir placé le matériau brut de cristal, on le balaye avec un gaz inerte et/ou on réalise la croissance sous vide.

15. Procédé selon l'une des revendications 8 à 14 qui précèdent, **caractérisé en ce que** l'on ajoute un ou plusieurs pièges au matériau brut du cristal.

16. Procédé selon l'une des revendications 8 à 15 qui précèdent, **caractérisé en ce que** l'on empêche l'écoulement thermique latéral au moyen d'un chauffage d'appoint (54) maintenu à distance des parois du creuset par un isolateur thermique (82).

17. Procédé selon l'une des revendications 8 à 16 qui précèdent, **caractérisé en ce qu'**au début de la croissance du cristal, on chauffe le chauffage de fond à une température d'au moins 650°C et le chauffage du couvercle à une température d'au moins 1 590°C.

18. Procédé selon l'une des revendications 8 à 17 qui précèdent, **caractérisé en ce que** l'on homogénéise le bain de fusion pendant une durée de 1 à 20 jours avant le début de la cristallisation.

19. Procédé selon l'une des revendications 8 à 18 qui précèdent, **caractérisé en ce que** le chauffage supérieur est maintenu constant et le chauffage inférieur est refroidi lentement.
